# EUROPEAN PATENT SPECIFICATION

(11) **EP 3 450 620 B1**
(45) Date of publication and mention of the grant of the patent: **31.07.2024**
(21) Application number: 17840710.2
(22) Date of filing: 23.01.2017
(51) Int. Cl.: D06N 3/00, D06N 3/12, H01L 31/048, H01L 31/18, H01L 31/049

(54) **PACKAGING MATERIAL FOR PHOTOVOLTAIC MODULE AND METHOD FOR PREPARING PACKAGING MATERIAL**
VERPACKUNGSMATERIAL FÜR FOTOVOLTAIKMODUL UND VERFAHREN ZUR HERSTELLUNG DES VERPACKUNGSMATERIALS
MATÉRIAU DE CONDITIONNEMENT D'UN MODULE PHOTOVOLTAÏQUE ET PROCÉDÉ DE PRÉPARATION D'UN MATÉRIAU DE CONDITIONNEMENT

(30) Priority: 18.08.2016 CN 201610685240
(43) Date of publication of application: 06.03.2019
(73) Proprietor: Tiger New Surface Materials (Suzhou) Co., Ltd., Suzhou Jiangsu 215400 (CN); Sunman (Shanghai) Co., Ltd., Shanghai 210700 (CN)
(72) Inventor: DAI, Tianhe, Jiangsu 215400 (CN); LUO, Biao, Jiangsu 215400 (CN); WANG, Zhicheng, Jiangsu 215400 (CN); LONG, Guozhu, Shanghai 210700 (CN); LIU, Jiaoyan, Shanghai 210700 (CN); LIAN, Chengrong, Shanghai 210700 (CN); WANG, Weili, Shanghai 210700 (CN)
(74) Representative: Meyer-Dulheuer MD Legal Patentanwälte PartG mbB
(86) International application number: PCT/CN2017/072150
(87) International publication number: WO 2018/032732

(56) References cited:
- CA-A1- 2 926 526
- CN-A- 101 671 518
- CN-A- 101 671 518
- CN-A- 102 408 550
- CN-A- 102 456 758
- CN-A- 102 456 758
- CN-A- 103 497 651
- CN-A- 106 283 677
- JP-A- H09 116 182
- US-A- 4 686 322
- US-A1- 2004 202 866
- US-A1- 2012 090 778

## Description

This disclosure relates to the photovoltaic field, and more particularly, to an encapsulant material for photovoltaic (PV) modules and a method of preparing the same.

At present, energy crisis and environmental issues are increasingly severe. It is a trend to develop various types of clean energy. In recent years, with the technological updating and rapid development of the photovoltaic industry, a plurality of photovoltaic products has been developed. For example, US 4686322 A recites a solar panel prepared from a substrate that contains plies of resin reinforced novoloid fabric; CA 2926526 A1 recites a photovoltaic panel including at least one solar cell that is covered with a transparent composite material; US 2012/090778 A1 recites a backsheet for a photovoltaic module; and CN 101671518 A recites a powder coating prepared from a polyester resin and a fluorocarbon resin. The research and development of multifunctional components with high reliability, high power and low installation cost have become a direction to develop photovoltaic modules.

Solar photovoltaic generation relies on solar cells to convert light energy into electricity. In the past ten years, the global output of photovoltaic cells has increased at an annual rate of over 40% on average. By the end of 2012, the installed capacity of photovoltaic power generation systems in the world had reached 100 GW. Photovoltaic power generation is expected to account for 10% of world energy supply in 2030, making a substantial contribution to the world's energy supply and energy structure.

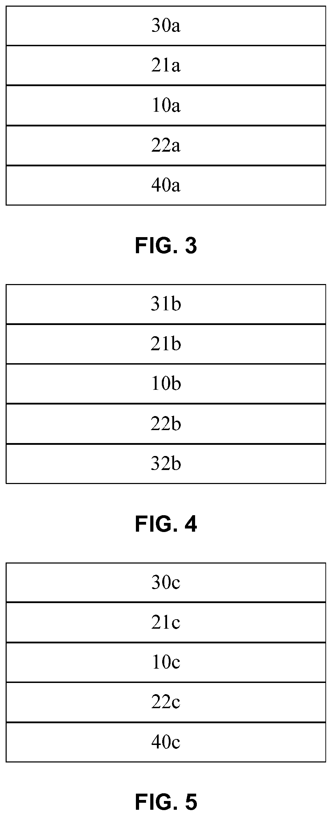

Typically, an encapsulant material used in the photovoltaic field requires anti-ultraviolet and anti-aging properties. As shown in FIG. 5, an encapsulant structure of conventional photovoltaic modules includes, from top to bottom, a tempered glass layer 30c, an upper ethylene-vinyl acetate (EVA) layer 21c, a photovoltaic cell layer 10c, a lower EVA layer 22c, and a backsheet layer 40c. The density of the tempered glass layer reaches 2.5 g/cm³, and the normal thickness of the tempered glass layer is 3.2 mm. Therefore, the tempered glass weights up to 8 kg per square meter, and the photovoltaic modules packaged by the encapsulant structure generally have a relatively large mass, and its weight is more than 10 kg per square meter. In combination with the installation and support structure, the total weight of the photovoltaic modules per square meter is at least 12 kg or more. When the photovoltaic modules are applied to the top of a building or a wall surface, etc., high strength requirements are placed on the supporting structure of the photovoltaic module, which increases the difficulty of construction and the installation cost. Specifically, in the process of installing the photovoltaic modules on the top or the wall of a building, the photovoltaic modules are so bulky, requiring high labor intensity and increasing the implementation difficulty. Particularly in some cases, due to the limitation of bearing capacity of the buildings, the photovoltaic modules cannot be installed. Meanwhile, the existing PV modules have a simple appearance and cannot be changed to meet the aesthetic requirements of different buildings.

Currently, there are some technical solutions attempting to reduce the weight of the photovoltaic modules by changing the encapsulant materials, that is, the use of highly transparent films and/or transparent backsheets to replace the tempered glass. However, in practice, because most of the highly transparent films and transparent backsheets are made of adhesive films such as ethylene-vinyl acetate (EVA) copolymer and poly(octene-ethylene) (POE), the encapsulated photovoltaic modules cannot meet the technical requirements of the photovoltaic industry in terms of impact resistance, fire resistance, and other properties.

There are also some technical solutions in the prior art to reduce the weight of photovoltaic modules. Chinese Patent Publication No. CN102516852A discloses a weatherproof solar backsheet including a high thermal conductivity and thermal dissipation coating. However, the production of the coating involves a large amount of solvent, which is very harmful to the environment and does not conform to the green environmental standard. Chinese Patent Publication No. CN102610680A discloses a photovoltaic backsheet with an UV curing weatherproof coating. The production of the coating involves a liquid coating process, which is lengthy, costly, and the resulting products have a high defective rate. Chinese Patent Publication Nos. CN102712184A, CN103346182A, CN102969382B, CN101290950B, and CN103958196A employ fluorine-containing polymers. The fluorine-containing polymers are expensive, increasing the production costs. In addition, the abovementioned photovoltaic backsheet materials are opaque, exhibit low hardness and weak rigidity, so are not suitable for replacing existing tempered glass.

Therefore, it is necessary to develop a photovoltaic module encapsulant material to solve the problem of heavy weight of the existing encapsulant materials, and meanwhile the photovoltaic module encapsulant material should meet the technical standards of the photovoltaic industry such as UV resistance, anti-aging, impact resistance, fire prevention and the like.

Disclosed is an encapsulant material for photovoltaic module that is inexpensive, light-weighted, can meet the technical standards of the photovoltaic industry such as UV resistance, anti-aging, impact resistance, fire prevention and the like. The light-weighted PV module encapsulant material is conducive to the installation, so it is very suitable for large-scale promotion and application in the photovoltaic field.

Also disclosed is a method of preparing an encapsulant material for a photovoltaic module. Through the method, the encapsulant dimensions of the PV modules can be arbitrarily changed to meet the installation requirements of different buildings, thus further facilitating the installation and application of the PV modules.

The disclosure adopts the following technical solutions.

Disclosed is an encapsulant material for a photovoltaic module, the encapsulant material comprising: between 30 and 50 parts by weight of a fiber cloth, the fiber cloth being formed by a fiber material; and between 50 and 70 parts by weight of weather resistant polyester powder coating, the weather resistant polyester powder coating comprising a weather resistant polyester resin and a curing agent, and the weather resistant polyester powder coating being evenly distributed on the fiber cloth.

The weight per unit area of the fiber cloth can be 30-400 g/m², and the weight per unit area of the weather resistant polyester powder coating distributed on the fiber cloth can be 100-400 g/m².

The fiber material can be glass fiber, carbon fiber, aramid fiber, or a mixture thereof.

The monofilament diameter of the fiber material can be between 3 and 23 µm.

The fiber cloth can comprise fiber material in the form of a plain weave, a twill weave, a satin weave, a rib weave, a mat weave, or a combination thereof.

The weather resistant polyester resin can be a hydroxyl weather resistant polyester resin, a carboxyl weather resistant polyester resin, or a mixture thereof.

The weather resistant polyester resin can be a polymer of monomers selected from terephthalic acid, m-phthalic acid, neopentyl glycol, adipic acid, ethylene glycol, or a mixture thereof.

The weather resistant polyester resin can be a hydroxyl weather resistant polyester resin having an acid value of between 30 and 300 mg KOH/g, a glass transition temperature of between 50 and 75°C, and a viscosity of between 15 and 200 Pa·s.

The weather resistant polyester resin can be a carboxyl weather resistant polyester resin having an acid value of between 15 and 85 mg KOH/g, a glass transition temperature of between 50 and 75°C, and a viscosity of between 15 and 200 Pa·s.

The curing agent can account for 2-20 wt. % of the weather resistant polyester powder coating, and the curing agent can be 1,3,5-triglycidyl isocyanurate, triglycidyl trimellitate (TML), diglycidyl terephthalate, glycidyl methacrylate (GMA), hydroxyalkyl amide, isocyanate, or a mixture thereof.

The weather resistant polyester powder coating can further comprise an additive; the additive can account for 0-40 wt. % of the weather resistant polyester powder coating, and the additive can be polyamide wax, polyolefine wax, amide modified phenolic urea surfactant, benzoin, poly(dimethylsiloxane), vinyl trichlorosilane, n-butyl triethoxyl silane, tetramethoxysilane (TMOS), monoalkoxy pyrophosphate, acrylics, phenolic resin, urea-formaldehyde resin, melamine formaldehyde resin, distearoyl ethylenediamine, a mixture of ethylene oxide and propylene oxide, hindered phenol, thiodipropionate, diphenyl ketone, salicylate derivatives, hindered amine, alumina, fumed silica, tetrabromobisphenol A, decabromodiphenyl ethane, tricresyl phosphate, aluminum hydroxide, magnesium hydroxide, barium sulfate, titanium dioxide, carbon black, or a mixture thereof.

Further disclosed is a method of preparing an encapsulant material for a photovoltaic module, the method comprising:
1) evenly distributing the weather resistant polyester powder coating on the fiber cloth using a coating device;
2) thermally bonding the weather resistant polyester powder coating and the fiber cloth using pressure and heat;
3) piecewise cutting a resulting product obtained by thermally bonding the weather resistant polyester powder coating and the fiber cloth in 2); and
4) collecting an encapsulant material for a photovoltaic module.

The thermally bonding can be implemented with the following parameters: a pressure is between 0.05 and 0.25 megapascal, a temperature is between 90 and 130°C, and a heating time is between 5 and 20 seconds.

The encapsulant material for a photovoltaic module of the disclosure comprises between 30 and 50 parts by weight of a fiber cloth and between 50 and 70 parts by weight of weather resistant polyester powder coating which is evenly distributed on the fiber cloth. The encapsulant material meets the technical standards of the photovoltaic industry such as UV resistance, anti-aging, impact resistance, fire prevention and the like, and is inexpensive, light-weighted, can replace the tempered glass of conventional encapsulant structure, and provide rigidity for the photovoltaic module to protect the photovoltaic cells. Thus, the weight of the photovoltaic module is greatly reduced, which facilitates the installation of the photovoltaic module in different occasions, reduces the labor intensity for installing the photovoltaic module, improves the convenience of installation, and reduces the installation cost of the photovoltaic module.

The preparation method of the encapsulant material comprises evenly distributing the weather resistant polyester powder coating on the fiber cloth, thermally bonding the weather resistant polyester powder coating and the fiber cloth using pressure and heat, and then piecewise cutting a resulting product obtained by thermally bonding the weather resistant polyester powder coating and the fiber cloth, to yield the encapsulant material. The dimensions of the PV module can be changed arbitrarily to meet the installation requirements of different buildings, which further facilitates the installation and application of the PV module.
FIG. 1 is a flow chart of a method of preparing an encapsulant material for a photovoltaic module in the disclosure;
FIG. 2 is schematic diagram of a device for preparing an encapsulant material for a photovoltaic module in the disclosure;
FIG. 3 is a schematic diagram of an encapsulant structure of a photovoltaic module using the encapsulant material in the disclosure;
FIG. 4 is another schematic diagram of an encapsulant structure of a photovoltaic module using the encapsulant material in the disclosure; and
FIG. 5 is a schematic diagram of an encapsulant structure of a photovoltaic module in the prior art.

The disclosure provides an encapsulant material for a photovoltaic module, the encapsulant material comprising: between 30 and 50 parts by weight of a fiber cloth, the fiber cloth being formed by fiber material; and between 50 and 70 parts by weight of weather resistant polyester powder coating, the weather resistant polyester powder coating comprising a weather resistant polyester resin and a curing agent, and the weather resistant polyester powder coating being evenly distributed on the fiber cloth.

The encapsulant material for a photovoltaic module of the disclosure comprises between 30 and 50 parts by weight of a fiber cloth and between 50 and 70 parts by weight of weather resistant polyester powder coating which is evenly distributed on the fiber cloth. The encapsulant material meets the technical standards of the photovoltaic industry such as UV resistance, anti-aging, impact resistance, fire prevention and the like, and is inexpensive, light-weighted, can replace the tempered glass of conventional encapsulant structure, and provide rigidity for the photovoltaic module to protect the photovoltaic cells. Thus, the weight of the photovoltaic module is greatly reduced, which facilitates the installation of the photovoltaic module in different occasions, reduces the labor intensity for installing the photovoltaic module, improves the convenience of installation, and reduces the installation cost of the photovoltaic module.

The disclosure also provides a method of preparing an encapsulant material for a photovoltaic module, the method comprising:
1) evenly distributing the weather resistant polyester powder coating on the fiber cloth;
2) thermally bonding the weather resistant polyester powder coating and the fiber cloth using pressure and heat;
3) piecewise cutting a resulting product obtained by thermally bonding the weather resistant polyester powder coating and the fiber cloth in 2); and
4) collecting an encapsulant material for a photovoltaic module.

The preparation method of the encapsulant material comprises evenly distributing the weather resistant polyester powder coating on the fiber cloth, thermally bonding the weather resistant polyester powder coating and the fiber cloth using pressure and heat, and then piecewise cutting a resulting product obtained by thermally bonding the weather resistant polyester powder coating and the fiber cloth, to yield the encapsulant material. The dimensions of the PV module can be changed arbitrarily to meet the installation requirements of different buildings, which further facilitates the installation and application of the PV module.

To more clearly explain the embodiments of the disclosure or the technical solutions in the prior art, the drawings used in the description of the embodiments or the prior art will be briefly described below. Obviously, the drawings in the following description are only some embodiments described in the disclosure, for those of ordinary skill in the art, other drawings may be obtained based on these drawings without any creative work.

### Example 1

An encapsulant material for a photovoltaic module, the encapsulant material comprises:
between 30 and 50 parts by weight of a fiber cloth, the fiber cloth being made of fiber material. Preferably, the fiber cloth can be made of fiber material in the form of a plain weave, a twill weave, a satin weave, a rib weave, a mat weave, or a combination thereof. Specifically, in this example, 30 parts by weight of a fiber cloth are employed, and the fiber cloth is made of fiber material in the form of plain weave. Optionally, one of ordinary skilled in the art can select other weaving methods according to actual needs.

Preferably, in this example, the weight per unit area of the fiber cloth can be 30-400 g/m², which can ensure the lightweight and the strength of the fiber cloth. Specifically, in this example, the weight per unit area of the fiber cloth can be 100 g/m².

Preferably, in this example, the fiber material can be glass fiber, carbon fiber, aramid fiber, or a mixture thereof, to ensure that the fiber cloth has good insulation and weather resistance. Specifically, in this example, the fiber material is glass fiber. Optionally, one of ordinary skilled in the art can select other types of fiber materials according to actual needs, and the embodiments of the disclosure will not describe this one by one.

Preferably, the monofilament diameter of the fiber material is between 3 and 23 µm. Specifically, in this example, the monofilament diameter of the fiber material is 3 µm. This facilitates the weaving of the fiber material and is conducive to preparation of the fiber cloth having the desired weight per unit area.

The encapsulant material further comprises between 50 and 70 parts by weight of weather resistant polyester powder coating. The weather resistant polyester powder coating comprises a weather resistant polyester resin and a curing agent. Specifically, in this example, 70 parts by weight of weather resistant polyester powder coating are employed.

Preferably, in this example, the weather resistant polyester resin is a hydroxyl weather resistant polyester resin, a carboxyl weather resistant polyester resin, or a mixture thereof. This can ensure the weather resistant polyester resin has good insulation and weather resistance. Preferably, the weather resistant polyester resin is hydroxyl weather resistant polyester resin.

Preferably, the hydroxyl weather resistant polyester resin is a polymer of monomers selected from neopentyl glycol, adipic acid, ethylene glycol, or a mixture thereof. Optionally, one of ordinary skilled in the art can select other types of monomers to synthesize the hydroxyl weather resistant polyester resin according to actual needs, and the embodiments of the disclosure will not describe this one by one. Preferably, the hydroxyl polyester resin is a polymer of adipic acid.

Preferably, in this example, the hydroxyl weather resistant polyester resin has an acid value of between 30 and 300 mg KOH/g, a glass transition temperature of between 50 and 75°C, and a viscosity of between 15 and 200 Pa·s. Particularly, the hydroxyl weather resistant polyester resin has an acid value of 100 mg KOH/g, a glass transition temperature of 60°C, and a viscosity of 80 Pa·s.

Preferably, in this example, the curing agent can account for 2-20 wt. % of the weather resistant polyester powder coating, and the curing agent is 1,3,5-triglycidyl isocyanurate, triglycidyl trimellitate (TML), diglycidyl terephthalate, glycidyl methacrylate (GMA), hydroxyalkyl amide, isocyanate, or a mixture thereof. Specifically, in this example, the curing agent is 1,3,5-triglycidyl isocyanurate which accounts for 5 wt. % of the weather resistant polyester powder coating. Optionally, one of ordinary skilled in the art can select other types of curing agent accounting for 2-20 wt. % (the end values 2% and 20% are included) of the weather resistant polyester powder coating according to actual needs, and the same technical effect can be achieved. The embodiments of the disclosure will not describe this one by one.

The weather resistant polyester powder coating is evenly distributed on the fiber cloth, and the weight per unit area of the weather resistant polyester powder coating can be 100-400 g/m². Specifically, in this example, the weight per unit area of the weather resistant polyester powder coating distributed on the fiber cloth is 100 g/m².

In certain examples, the weather resistant polyester powder coating further comprises an additive. Preferably, the additive can account for 0-40 wt. % of the weather resistant polyester powder coating, which is conducive to improving the insulation and weather resistance of the weather resistant polyester powder coating. In addition, according to the actual installation requirements of the photovoltaic modules, the color of the weather resistant polyester powder coating can be adjusted by adding the additive, which further benefits the practical installation and application of the photovoltaic module. Specifically, the additive is polyamide wax, polyolefine wax, amide modified phenolic urea surfactant, benzoin, poly(dimethylsiloxane), vinyl trichlorosilane, n-butyl triethoxyl silane, tetramethoxysilane (TMOS), monoalkoxy pyrophosphate, acrylics, phenolic resin, urea-formaldehyde resin, melamine formaldehyde resin, distearoyl ethylenediamine, a mixture of ethylene oxide and propylene oxide, hindered phenol, thiodipropionate, diphenyl ketone, salicylate derivatives, hindered amine, alumina, fumed silica, tetrabromobisphenol A, decabromodiphenyl ethane, tricresyl phosphate, aluminum hydroxide, magnesium hydroxide, barium sulfate, titanium dioxide, carbon black, or a mixture thereof in any ratio. Optionally, one of ordinary skilled in the art can select other types of additives according to actual needs, and the embodiments of the disclosure will not describe this one by one.

The weather resistant polyester powder coating of the disclosure can be prepared using any of the known preparation techniques for powder coatings. Typical methods include premixing, melt extrusion, and milling. Specifically, in this example, the weather resistant polyester resin is premixed with the curing agent, preferably, the premixing time is between 2 and 10 min (when the weather resistant polyester powder coating comprises an additive, the additive can be premixed together). Thereafter, the premixed mixture is extruded and pressed into thin slices with a screw extruder. The aspect ratio of the extruder can be set at between 15:1 and 50:1. The screw extruder is heated to between 80 and 120°C, and rotates at 200-800 rpm. The thin slices are crushed into small pieces which are conveyed to a powder mill to be ground into a powder coating having certain particle sizes. Preferably, the rotational speed of the powder mill is 50-150 rpm. The particle size of the weather resistant polyester powder coating is 35-300 µm. Optionally, the weather resistant polyester powder coating can be prepared using other process parameters or preparation processes; these parameters or preparation processes are familiar to one of ordinary skill in the art, so the embodiments of the disclosure will not describe this in detail.

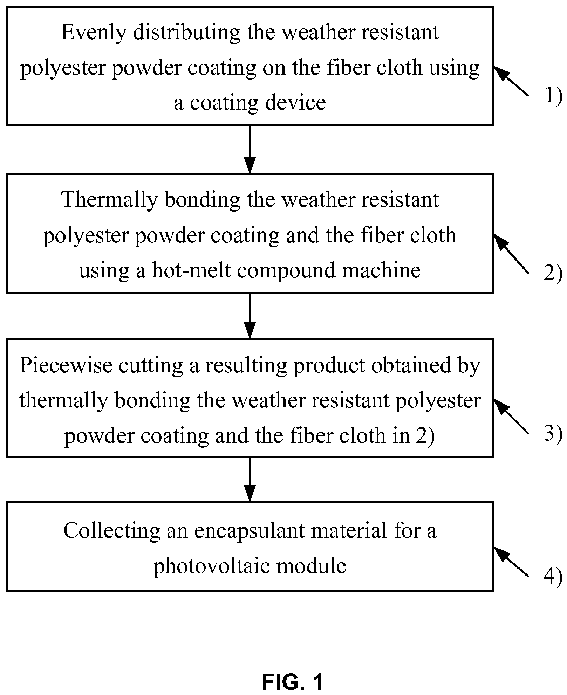

As shown in FIG. 1, a method of preparing an encapsulant material for a photovoltaic module comprises:
1) evenly distributing the weather resistant polyester powder coating on the fiber cloth;
2) thermally bonding the weather resistant polyester powder coating and the fiber cloth using pressure and heat;
3) piecewise cutting a resulting product obtained by thermally bonding the weather resistant polyester powder coating and the fiber cloth in 2); and
4) collecting an encapsulant material for a photovoltaic module.

In this example, thermally bonding the weather resistant polyester powder coating and the fiber cloth is achieved under appropriate pressure and heat. It is only under appropriate pressure and temperature that a thermal bonding can be achieved between the weather resistant polyester powder coating and the fiber cloth, thus fulfilling the laminating requirement in the process of preparing the photovoltaic module, so as to prepare the encapsulant materials that can effectively apply to the encapsulant of the photovoltaic cell components. Preferably, during the thermal bonding, the pressure is between 0.05 and 0.25 megapascal, the temperature is between 90 and 130°C, and the heating time is between 5 and 20 seconds. Specifically, the pressure is 0.05 megapascal, the temperature is 130°C, and the heating time is 5 seconds.

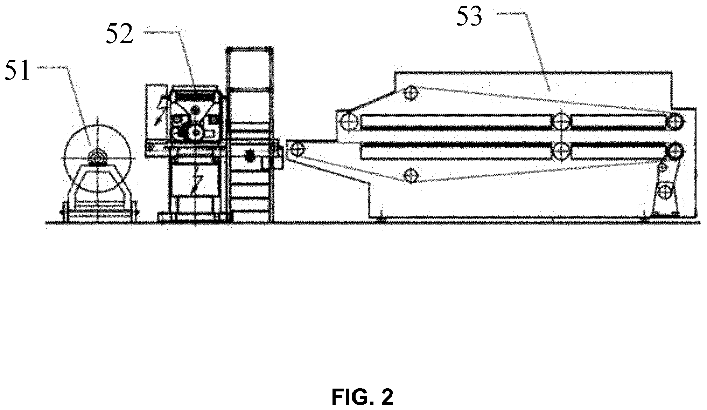

Preferably, FIG. 2 illustrates a device for preparing the encapsulant material for a photovoltaic module. In the production process, the fiber cloth is put into a fiber feeder 51, and then the weather resistant polyester powder coating is evenly distributed on the fiber cloth output from the fiber feeder 51 by a coating device 52. Thereafter, the weather resistant polyester powder coating and the fiber cloth are thermally bonded under the pressure and heat produced by a hot-melt compound machine 53. The thermally bonded weather resistant polyester powder coating and the fiber cloth is piecewise cut, to yield an encapsulant material for a photovoltaic module. In other embodiments of the disclosure, the coating device can be a dusting head. The coating device implements the coating process in the form of powder dusting, and the weather resistant polyester powder coating is evenly distributed on the fiber cloth. Optionally, one of ordinary skill in the art can select other known devices to prepare the encapsulant material for photovoltaic modules.

FIG. 3 illustrates an encapsulant structure of a photovoltaic module using the encapsulant material. The photovoltaic encapsulant structure comprises, from top to bottom, an encapsulant material layer 30a, an upper EVA layer 21a, a photovoltaic cell layer 10a, a lower EVA layer 22a, and a backsheet layer 40a. The encapsulant material layer 30a substitutes for conventional tempered glass layer. One of ordinary skill in the art may use the encapsulant material of the embodiment of the disclosure to replace other encapsulant structures or to replace other layer structures in combination with other materials according to the actual needs and the conditions of the installation site, and the disclosure does not make specific restrictions on this. FIG. 4 illustrates another encapsulant structure of a photovoltaic module using the encapsulant material. The photovoltaic encapsulant structure comprises, from top to bottom, an upper encapsulant material layer 31b, an upper EVA layer 21b, a photovoltaic cell layer 10b, a lower EVA layer 22b, and a lower encapsulant material layer 32b. The upper encapsulant material layer 31b and the lower encapsulant material layer 32b substitutes for conventional tempered glass layer and backsheet layer, respectively.

### Example 2

In this example, the encapsulant structure of a photovoltaic module comprises the following components:
35 parts by weight of a fiber cloth; the fiber cloth is made of fiber material in the form of twill weave;
the weight per unit area of the fiber cloth is 30 g/m²;
the fiber material is carbon fiber;
the monofilament diameter of the fiber material is 5 µm;
65 parts by weight of weather resistant polyester powder coating; the weather resistant polyester powder coating comprising a weather resistant polyester resin, a curing agent and an additive;
the weather resistant polyester resin is a carboxyl weather resistant polyester resin which is a polymer of monomers selected from terephthalic acid, m-phthalic acid, or a mixture thereof; the carboxyl weather resistant polyester resin has an acid value of between 15 and 85 mg KOH/g, a glass transition temperature of between 50 and 75°C, and a viscosity of between 15 and 200 Pa·s; specifically, the carboxyl weather resistant polyester resin is a polymer of terephthalic acid, and has an acid value of 85 mg KOH/g, a glass transition temperature of 75°C, and a viscosity of 200 Pa·s;
the curing agent is triglycidyl trimellitate (TML), which accounts for 6 wt. % of the weather resistant polyester powder coating;
the additive is a mixture of polyamide wax, polyolefine wax, amide modified phenolic urea surfactant, benzoin, hindered phenol, thiodipropionate, diphenyl ketone, salicylate derivatives, hindered amine, alumina, magnesium hydroxide, barium sulfate, titanium dioxide, carbon black in any ratio, and accounts for 40 wt. % of the weather resistant polyester powder coating;
the weight per unit area of the weather resistant polyester powder coating distributed on the fiber cloth is 150 g/m²;
during the thermal bonding for preparing the encapsulant material, the pressure is 0.1 megapascal, the temperature is 120°C, and the heating time is 8 seconds;
other technical solutions in Example 2 are the same as that in Example 1.

### Example 3

In this example, the encapsulant structure of a photovoltaic module comprises the following components:
40 parts by weight of a fiber cloth; the fiber cloth is made of fiber material in the form of satin weave;
the weight per unit area of the fiber cloth is 50 g/m²;
the fiber material is aramid fiber;
the monofilament diameter of the fiber material is 8 µm;
60 parts by weight of weather resistant polyester powder coating; the weather resistant polyester powder coating comprising a weather resistant polyester resin, a curing agent and an additive;
the weather resistant polyester resin is a polymer of monomers of neopentyl glycol;
the hydroxyl weather resistant polyester resin has an acid value of 30 mg KOH/g, a glass transition temperature of 50°C, and a viscosity of 15 Pa·s;
the curing agent is diglycidyl terephthalate, which accounts for 8 wt. % of the weather resistant polyester powder coating;
the additive is a mixture of poly(dimethylsiloxane), vinyl trichlorosilane, n-butyl triethoxyl silane, tetramethoxysilane (TMOS), monoalkoxy pyrophosphate, decabromodiphenyl ethane, tricresyl phosphate, aluminum hydroxide, barium sulfate in any ratio, and accounts for 35 wt. % of the weather resistant polyester powder coating;
the weight per unit area of the weather resistant polyester powder coating distributed on the fiber cloth is 200 g/m²;
during the thermal bonding for preparing the encapsulant material, the pressure is between 0.15 megapascal, the temperature is 100°C, and the heating time is 10 seconds;
other technical solutions in Example 3 are the same as that in Example 1.

### Example 4

In this example, the encapsulant structure of a photovoltaic module comprises the following components:
45 parts by weight of a fiber cloth; the fiber cloth is made of fiber material in the form of rib weave;
the weight per unit area of the fiber cloth is 80 g/m²;
the monofilament diameter of the fiber material is 10 µm;
55 parts by weight of weather resistant polyester powder coating; the weather resistant polyester powder coating comprising a weather resistant polyester resin, a curing agent and an additive;
the weather resistant polyester resin is a polymer of monomers of ethylene glycol;
the hydroxyl weather resistant polyester resin has an acid value of 50 mg KOH/g, a glass transition temperature of 55°C, and a viscosity of 35 Pa·s;
the curing agent is diglycidyl terephthalate, which accounts for 8 wt. % of the weather resistant polyester powder coating;
the additive is a mixture of hindered phenol, thiodipropionate, diphenyl ketone, salicylate derivatives, hindered amine, alumina, barium sulfate in any ratio, and accounts for 30 wt. % of the weather resistant polyester powder coating;
the weight per unit area of the weather resistant polyester powder coating distributed on the fiber cloth is 250 g/m²;
during the thermal bonding for preparing the encapsulant material, the pressure is between 0.18 megapascal, the temperature is 115°C, and the heating time is 8 seconds;
other technical solutions in Example 4 are the same as that in Example 1.

### Example 5

In this example, the encapsulant structure of a photovoltaic module comprises the following components:
50 parts by weight of a fiber cloth; the fiber cloth is made of fiber material in the form of mat weave;
the weight per unit area of the fiber cloth is 120 g/m²;
the monofilament diameter of the fiber material is 13 µm;
50 parts by weight of weather resistant polyester powder coating; the weather resistant polyester powder coating comprising a weather resistant polyester resin, a curing agent and an additive;
the weather resistant polyester resin is a polymer of monomers of neopentyl glycol and adipic acid;
the hydroxyl weather resistant polyester resin has an acid value of 80 mg KOH/g, a glass transition temperature of 58°C, and a viscosity of 70 Pa·s;
the curing agent is glycidyl methacrylate (GMA), which accounts for 10 wt. % of the weather resistant polyester powder coating;
the additive is a mixture of melamine formaldehyde resin, distearoyl ethylenediamine, a mixture of ethylene oxide and propylene oxide, hindered phenol, thiodipropionate, and diphenyl ketone, and accounts for 20 wt. % of the weather resistant polyester powder coating;
the weight per unit area of the weather resistant polyester powder coating distributed on the fiber cloth is 300 g/m²;
during the thermal bonding for preparing the encapsulant material, the pressure is between 0.2 megapascal, the temperature is 118°C, and the heating time is 6 seconds;
other technical solutions in Example 5 are the same as that in Example 1.

### Example 6

In this example, the encapsulant structure of a photovoltaic module comprises the following components:
38 parts by weight of a fiber cloth; the fiber cloth is made of fiber material in the form of hybrid of plain weave and twill weave;
the weight per unit area of the fiber cloth is 150 g/m²;
the monofilament diameter of the fiber material is 16 µm;
62 parts by weight of weather resistant polyester powder coating; the weather resistant polyester powder coating comprising a weather resistant polyester resin, a curing agent and an additive;
the weather resistant polyester resin is a polymer of monomers of adipic acid and ethylene glycol;
the hydroxyl weather resistant polyester resin has an acid value of 150 mg KOH/g, a glass transition temperature of 65°C, and a viscosity of 100 Pa·s;
the curing agent is isocyanate, which accounts for 12 wt. % of the weather resistant polyester powder coating;
the additive is a mixture of polyamide wax, phenolic resin, ethylene oxide, propylene oxide, and magnesium hydroxide in any ratio, and accounts for 35 wt. % of the weather resistant polyester powder coating;
the weight per unit area of the weather resistant polyester powder coating distributed on the fiber cloth is 350 g/m²;
during the thermal bonding for preparing the encapsulant material, the pressure is between 0.25 megapascal, the temperature is 95°C, and the heating time is 15 seconds;
other technical solutions in Example 6 are the same as that in Example 1.

### Example 7

In this example, the encapsulant structure of a photovoltaic module comprises the following components:
33 parts by weight of a fiber cloth; the fiber cloth is made of fiber material in the form of hybrid of plain weave and satin weave;
the weight per unit area of the fiber cloth is 180 g/m²;
the monofilament diameter of the fiber material is 18 µm;
67 parts by weight of weather resistant polyester powder coating; the weather resistant polyester powder coating comprising a weather resistant polyester resin, a curing agent and an additive;
the weather resistant polyester resin is a polymer of monomers of adipic acid and ethylene glycol;
the hydroxyl weather resistant polyester resin has an acid value of 200 mg KOH/g, a glass transition temperature of 70°C, and a viscosity of 150 Pa·s;
the curing agent is isocyanate, which accounts for 15 wt. % of the weather resistant polyester powder coating;
the additive is a mixture of vinyl trichlorosilane, n-butyl triethoxyl silane, tetramethoxysilane (TMOS), monoalkoxy pyrophosphate in any ratio, and accounts for 8 wt. % of the weather resistant polyester powder coating;
the weight per unit area of the weather resistant polyester powder coating distributed on the fiber cloth is 400 g/m²;
during the thermal bonding for preparing the encapsulant material, the pressure is between 0.22 megapascal, the temperature is 105°C, and the heating time is 20 seconds;
other technical solutions in Example 7 are the same as that in Example 1.

### Example 8

In this example, the encapsulant structure of a photovoltaic module comprises the following components:
42 parts by weight of a fiber cloth; the fiber cloth is made of fiber material in the form of hybrid of plain weave and satin weave;
the weight per unit area of the fiber cloth is 200 g/m²;
the monofilament diameter of the fiber material is 18 µm;
58 parts by weight of weather resistant polyester powder coating; the weather resistant polyester powder coating comprising a weather resistant polyester resin, a curing agent and an additive;
the carboxyl weather resistant polyester resin has an acid value of 35 mg KOH/g, a glass transition temperature of 72°C, and a viscosity of 180 Pa·s;
the curing agent is 1,3,5-triglycidyl isocyanurate, which accounts for 10 wt. % of the weather resistant polyester powder coating;
the additive is a mixture of acrylics, phenolic resin, urea-formaldehyde resin, melamine formaldehyde resin in any ratio, and accounts for 5 wt. % of the weather resistant polyester powder coating;
during the thermal bonding for preparing the encapsulant material, the pressure is between 0.16 megapascal, the temperature is 98°C, and the heating time is 18 seconds;
other technical solutions in Example 8 are the same as that in Example 1.

### Example 9

In this example, the encapsulant structure of a photovoltaic module comprises the following components:
48 parts by weight of a fiber cloth; the fiber cloth is made of fiber material in the form of hybrid of satin weave and rib weave;
the weight per unit area of the fiber cloth is 250 g/m²;
the fiber material is carbon fiber;
the monofilament diameter of the fiber material is 20 µm;
52 parts by weight of weather resistant polyester powder coating; the weather resistant polyester powder coating comprising a weather resistant polyester resin, a curing agent and an additive;
the weather resistant polyester resin is a polymer of monomers of m-phthalic acid;
the carboxyl weather resistant polyester resin has an acid value of 30 mg KOH/g, a glass transition temperature of 70°C, and a viscosity of 150 Pa·s;
the curing agent accounts for 5 wt. % of the weather resistant polyester powder coating;
during the thermal bonding for preparing the encapsulant material, the pressure is between 0.18 megapascal, the temperature is 100°C, and the heating time is 16 seconds;
other technical solutions in Example 9 are the same as that in Example 2.

### Example 10

In this example, the encapsulant structure of a photovoltaic module comprises the following components:
46 parts by weight of a fiber cloth; the fiber cloth is made of fiber material in the form of hybrid of plain weave, twill weave, and mat weave;
the weight per unit area of the fiber cloth is 300 g/m²;
the fiber material is a mixture of glass fiber and aramid fiber;
the monofilament diameter of the fiber material is 23 µm;
54 parts by weight of weather resistant polyester powder coating; the weather resistant polyester powder coating comprising a weather resistant polyester resin, a curing agent and an additive;
the weather resistant polyester resin is a polymer of monomers of m-phthalic acid; the carboxyl weather resistant polyester resin has an acid value of 60 mg KOH/g, a glass transition temperature of 65°C, and a viscosity of 120 Pa s;
the curing agent accounts for 8 wt. % of the weather resistant polyester powder coating;
other technical solutions in Example 10 are the same as that in Example 2.

### Example 11

In this example, the encapsulant structure of a photovoltaic module comprises the following components:
36 parts by weight of a fiber cloth; the fiber cloth is made of fiber material in the form of hybrid of plain weave, twill weave, and mat weave;
the weight per unit area of the fiber cloth is 350 g/m²;
the fiber material is a mixture of glass fiber and carbon fiber;
the monofilament diameter of the fiber material is 14 µm;
64 parts by weight of weather resistant polyester powder coating; the weather resistant polyester powder coating comprising a weather resistant polyester resin, a curing agent and an additive;
the weather resistant polyester resin is a polymer of monomers of terephthalic acid and m-phthalic acid;
the carboxyl weather resistant polyester resin has an acid value of 50 mg KOH/g, a glass transition temperature of 62°C, and a viscosity of 80 Pa·s;
the curing agent accounts for 10 wt. % of the weather resistant polyester powder coating;
other technical solutions in Example 11 are the same as that in Example 2.

### Example 12

In this example, the encapsulant structure of a photovoltaic module comprises the following components:
35 parts by weight of a fiber cloth; the fiber cloth is made of fiber material in the form of hybrid of plain weave, twill weave, and mat weave;
the weight per unit area of the fiber cloth is 400 g/m²;
the monofilament diameter of the fiber material is 23 µm;
65 parts by weight of weather resistant polyester powder coating; the weather resistant polyester powder coating comprising a weather resistant polyester resin, a curing agent and an additive;
the weather resistant polyester resin is a polymer of monomers of terephthalic acid and m-phthalic acid;
the carboxyl weather resistant polyester resin has an acid value of 30 mg KOH/g, a glass transition temperature of 58°C, and a viscosity of 60 Pa·s;
the curing agent accounts for 14 wt. % of the weather resistant polyester powder coating;
other technical solutions in Example 12 are the same as that in Example 2.

### Example 13

In this example, the technical solutions are the same as that in Example 1 except that, in this example, the weight per unit area of the fiber cloth is 130 g/m²; and the weight per unit area of the weather resistant polyester powder coating distributed on the fiber cloth is 180 g/m².

### Example 14

In this example, the technical solutions are the same as that in Example 2 except that, in this example, the carboxyl weather resistant polyester resin has an acid value of 15 mg KOH/g, a glass transition temperature of 50°C, and a viscosity of 15 Pa·s; the curing agent accounts for 16 wt. % of the weather resistant polyester powder coating; the weight per unit area of the fiber cloth is 80 g/m²; and the weight per unit area of the weather resistant polyester powder coating distributed on the fiber cloth is 280 g/m².

### Comparison example 1

The encapsulant material in this example is a typical encapsulant material as described in the background.

### Comparison example 2

The encapsulant material in this example employs an ethylene-vinyl acetate (EVA) copolymer adhesive film as described in the background.

### Comparison example 3

The encapsulant material in this example employs poly(octene-ethylene) (POE) adhesive film as described in the background.

### Comparison example 4

In this example, the technical solutions are the same as that in Example 1 except that, in this example, the encapsulant material comprises 30 parts by weight of a fiber cloth and commercial epoxy powder coatings.

The comparisons of the implementation effect of the encapsulant materials in the examples and the comparison examples of the disclosure are listed in Table 1:

**Table 1 Comparisons of implementation effect of the encapsulant materials in the examples and the comparison examples of the disclosure**

| Test items | Weight of encapsulant structure | Impact resistance | | |
|---|---|---|---|---|
| | | Appearanc e | Maximum power degradation | Insulation resistance |
| Example 1 | ≤ 1 kg/m², easy to install | No defects | ≤ 5% | ≥40 MΩ·m² |
| Example 2 | ≤ 1 kg/m², easy to install | No defects | ≤ 5% | ≥40 MΩ·m² |
| Example 3 | ≤ 1 kg/m², easy to install | No defects | ≤ 5% | ≥40 MΩ·m² |
| Example 4 | ≤ 1 kg/m², easy to install | No defects | ≤ 5% | ≥40 MΩ·m² |
| Example 5 | ≤ 1 kg/m², easy to install | No defects | ≤ 5% | ≥40 MΩ·m² |
| Example 6 | ≤ 1 kg/m², easy to install | No defects | ≤ 5% | ≥40 MΩ·m² |
| Example 7 | ≤ 1 kg/m², easy to install | No defects | ≤ 5% | ≥40 MΩ·m² |
| Example 8 | ≤ 1 kg/m², easy to install | No defects | ≤ 5% | ≥40 MΩ·m² |
| Example 9 | ≤ 1 kg/m², easy to install | No defects | ≤ 5% | ≥40 MΩ·m² |
| Example 10 | ≤ 1 kg/m², easy to install | No defects | ≤ 5% | ≥40 MΩ·m² |
| Example 11 | ≤ 1 kg/m², easy to install | No defects | ≤ 5% | ≥40 MΩ·m² |
| Example 12 | ≤ 1 kg/m², easy to install | No defects | ≤ 5% | ≥40 MΩ·m² |
| Example 13 | ≤ 1 kg/m², easy to install | No defects | ≤ 5% | ≥40 MΩ·m² |
| Example 14 | ≤ 1 kg/m², easy to install | No defects | ≤ 5% | ≥40 MΩ·m² |
| Comparison example 1 | ≥8 kg/m², difficult to install | No defects | ≤ 5% | ≥40 MΩ·m² |
| Comparison example 2 | ≤ 1 kg/m², easy to install | No defects | >5% | <40 MΩ·m² |
| Comparison example 3 | ≤ 1 kg/m², easy to install | No defects | >5% | <40 MΩ·m² |
| Comparison example 4 | ≤ 1 kg/m², easy to install | No defects | ≤ 5% | ≥40 MΩ·m² |

**(Continued)**

| Test items | Fire resistance | Pencil hardness | Tensile strength | Elongation at break | Weathering test |
|---|---|---|---|---|---|
| Example 1 | Self-extinguishing, non-combustion | 1H satisfied | 25-35 megapascal | 150-250% | Successful |
| Example 2 | Self-extinguishing, non-combustion | 1H satisfied | 25-35 megapascal | 150-250% | Successful |
| Example 3 | Self-extinguishing, non-combustion | 1H satisfied | 25-35 megapascal | 150-250% | Successful |
| Example 4 | Self-extinguishing, non-combustion | 1H satisfied | 25-35 megapascal | 150-250% | Successful |
| Example 5 | Self-extinguishing, non-combustion | 1H satisfied | 25-35 megapascal | 150-250% | Successful |
| Example 6 | Self-extinguishing, non-combustion | 1H satisfied | 25-35 megapascal | 150-250% | Successful |
| Example 7 | Self-extinguishing, non-combustion | 1H satisfied | 25-35 megapascal | 150-250% | Successful |
| Example 8 | Self-extinguishing, non-combustion | 1H satisfied | 25-35 megapascal | 150-250% | Successful |
| Example 9 | Self-extinguishing, non-combustion | 1H satisfied | 25-35 megapascal | 150-250% | Successful |
| Example 10 | Self-extinguishing, non-combustion | 1H satisfied | 25-35 megapascal | 150-250% | Successful |
| Example 11 | Self-extinguishing, non-combustion | 1H satisfied | 25-35 megapascal | 150-250% | Successful |
| Example 12 | Self-extinguishing, non-combustion | 1H satisfied | 25-35 megapascal | 150-250% | Successful |
| Example 13 | Self-extinguishing, non-combustion | 1H satisfied | 25-35 megapascal | 150-250% | Successful |
| Example 14 | Self-extinguishing, non-combustion | 1H satisfied | 25-35 megapascal | 150-250% | Successful |
| Comparison example 1 | Self-extinguishing, non-combustion | 1H satisfied | 42 megapascal | 2-3% | Successful |
| Comparison example 2 | Combustible | 1H, unsatisfied | 16 megapascal | 550% | Successful |
| Comparison example 3 | Combustible | 1H, unsatisfied | 18 megapascal | 350% | Successful |
| Comparison example 4 | Self-extinguishing, non-combustion | 1H satisfied | 80-90 megapascal | 50-70% | Failed |

The weight of the encapsulant structure in the disclosure refers to the weight per unit square meter of the encapsulant material of the PV module. The impact resistance test is implemented as follows: an ice hockey with the standard diameter of 25 mm and the mass of 7.53 g is launched at the speed of 23.0 m/s to impact eleven positions of the packaged photovoltaic module, and then the impact resistance of the photovoltaic module is judged by the appearance, the maximum power degradation and the insulation resistance. The fire resistance is measured according to the UL1703 standard. The pencil hardness is measured according to the ASTM D3363-2005 (R2011) standard. The tensile strength is measured according to the GBIT 1040.3-2006 standard. The elongation at break is measured according to the GBIT 1040.3-2006 standard.

Based on the test data in Table 1, the encapsulant material meets the technical standards of the photovoltaic industry such as UV resistance, anti-aging, impact resistance, fire prevention and the like, and is inexpensive, light-weighted, can replace the tempered glass of conventional encapsulant structure, and provide rigidity for the photovoltaic module to protect the photovoltaic cells. Thus, the weight of the photovoltaic module is greatly reduced, which facilitates the installation of the photovoltaic module in different occasions, reduces the labor intensity for installing the photovoltaic module, improves the convenience of installation, and reduces the installation cost of the photovoltaic module.

In addition, the preparation method of the encapsulant material comprises evenly distributing the weather resistant polyester powder coating on the fiber cloth, thermally bonding the weather resistant polyester powder coating and the fiber cloth using pressure and heat, and then piecewise cutting the thermally bonded weather resistant polyester powder coating and the fiber cloth, to yield the encapsulant material. The dimensions of the PV module can be changed arbitrarily to meet the installation requirements of different buildings, which further facilitates the installation and application of the PV module.

Although the encapsulant material taught in this disclosure can be applied to the encapsulant of the photovoltaic modules with excellent implementation effect, the photovoltaic field is not the only application field of the material. One of ordinary in the art should apply the encapsulant material to other suitable fields, according to the actual needs and the characteristics and the actual performance of the encapsulant material of the disclosure, which involves no creative work and still belongs to the spirit of the disclosure, so such an application is also considered to be as the scope of the protection of the rights of the disclosure.

For those skilled in the art, it is clear that the invention is not limited to the details of the above exemplary embodiments, and that the invention can be realized in other specific forms without departing from the spirit or basic characteristics of the invention. Therefore, at any point, the implementation should be regarded as exemplary and unrestrictive, and the scope of the invention is defined by the appended claims rather than the above description, and therefore aims to include all the changes within the meaning and scope of the equivalent elements of the claim. Any appended drawing reference signs in the claims shall not be regarded as restrictions on the claims.

Unless otherwise indicated, the numerical ranges involved include the beginning and end values. It will be obvious to those skilled in the art that changes and modifications may be made, and therefore, the aim in the appended claims is to cover all such changes and modifications.

## Claims

1. An encapsulant material for a photovoltaic module, the encapsulant material comprising:
between 30 and 50 parts by weight of a fiber cloth, the fiber cloth being formed by a fiber material; and
between 50 and 70 parts by weight of a weather resistant polyester powder coating, the weather resistant polyester powder coating comprising a weather resistant polyester resin and a curing agent, and the weather resistant polyester powder coating being evenly distributed on the fiber cloth.

2. The encapsulant material of claim 1, **characterized in that** a weight per unit area of the fiber cloth is between 30 and 400 g/m², and a weight per unit area of the weather resistant polyester powder coating distributed on the fiber cloth is between 100 and 400 g/m².

3. The encapsulant material of claim 1, **characterized in that** the fiber material is glass fiber, carbon fiber, aramid fiber, or a mixture thereof.

4. The encapsulant material of claim 1, **characterized in that** a monofilament diameter of the fiber material is between 3 and 23 µm.

5. The encapsulant material of claim 1, **characterized in that** the fiber cloth comprises fiber material in the form of a plain weave, a twill weave, a satin weave, a rib weave, a mat weave, or a combination thereof.

6. The encapsulant material of claim 1, **characterized in that** the weather resistant polyester resin is a hydroxyl weather resistant polyester resin, a carboxyl weather resistant polyester resin, or a mixture thereof.

7. The encapsulant material of claim 6, **characterized in that** the weather resistant polyester resin is a polymer of monomers selected from terephthalic acid, m-phthalic acid, neopentyl glycol, adipic acid, ethylene glycol, or a mixture thereof.

8. The encapsulant material of claim 1, **characterized in that** the curing agent accounts for 2-20 wt. % of the weather resistant polyester powder coating, and the curing agent is 1,3,5-triglycidyl isocyanurate, triglycidyl trimellitate (TML), diglycidyl terephthalate, glycidyl methacrylate (GMA), hydroxyalkyl amide, isocyanate, or a mixture thereof.

9. The encapsulant material of claim 8, **characterized in that** the weather resistant polyester powder coating further comprises an additive; the additive accounts for 0-40 wt. % of the weather resistant polyester powder coating, and the additive is polyamide wax, polyolefine wax, amide modified phenolic urea surfactant, benzoin, poly(dimethylsiloxane), vinyl trichlorosilane, n-butyl triethoxyl silane, tetramethoxysilane (TMOS), monoalkoxy pyrophosphate, acrylics, phenolic resin, urea-formaldehyde resin, melamine formaldehyde resin, distearoyl ethylenediamine, a mixture of ethylene oxide and propylene oxide, hindered phenol, thiodipropionate, diphenyl ketone, salicylate derivatives, hindered amine, alumina, fumed silica, tetrabromobisphenol A, decabromodiphenyl ethane, tricresyl phosphate, aluminum hydroxide, magnesium hydroxide, barium sulfate, titanium dioxide, carbon black, or a mixture thereof.

10. A method of preparing an encapsulant material for a photovoltaic module of any one of claims 1-9, the method comprising:
1) evenly distributing the weather resistant polyester powder coating on the fiber cloth using a coating device;
2) thermally bonding the weather resistant polyester powder coating and the fiber cloth using pressure and heat;
3) piecewise cutting a resulting product obtained by thermally bonding the weather resistant polyester powder coating and the fiber cloth in 2); and
4) collecting an encapsulant material for a photovoltaic module.

11. The method of claim 10, **characterized in that** the thermally bonding is implemented with the following parameters: a pressure is between 0.05 and 0.25 megapascal, a temperature is between 90 and 130°C, and a heating time is between 5 and 20 seconds.

## Patentansprüche

1. Einkapselungsmaterial für ein photovoltaisches Modul, wobei das Einkapselungsmaterial Folgendes umfasst:
zwischen 30 und 50 Gewichtsteilen eines Fasergewebes, wobei das Fasergewebe aus einem Fasermaterial besteht; und
zwischen 50 und 70 Gewichtsteilen einer witterungsbeständigen Polyester-Pulverbeschichtung, wobei die witterungsbeständige Polyester-Pulverbeschichtung ein witterungsbeständiges Polyesterharz und ein Härtungsmittel umfasst, und die witterungsbeständige Polyester-Pulverbeschichtung gleichmäßig auf dem Fasergewebe verteilt ist.

2. Einkapselungsmaterial nach Anspruch 1, **dadurch gekennzeichnet, dass** das Flächengewicht des Fasergewebes zwischen 30 und 400 g/m² liegt und das Flächengewicht de r witterungsbeständigen Polyester-Pulverbeschichtung, die auf dem Fasergewebe verteilten, zwischen 100 und 400 g/m² beträgt.

3. Einkapselungsmaterial nach Anspruch 1, **dadurch gekennzeichnet, dass** das Fasermaterial eins oder eine Kombination aus Glasfaser, Kohlenstofffaser und Aramidfaser ist.

4. Einkapselungsmaterial nach Anspruch 1, **dadurch gekennzeichnet, dass** der Monofilamentdurchmesser des Fasermaterials zwischen 3 und 23 µm beträgt.

5. Einkapselungsmaterial nach Anspruch 1, **dadurch gekennzeichnet, dass** das Fasergewebe Fasermaterial mit einer beliebigen Webart oder einer Kombination mehrerer Webarten in Leinwand-, Köper-, Satin-, Rippen- oder Mattenbindung umfasst.

6. Einkapselungsmaterial nach Anspruch 1, **dadurch gekennzeichnet, dass** das witterungsbeständige Polyesterharz ein witterungsbeständiges Hydroxylpolyesterharz, ein Carboxylpolyesterharz oder eine Mischung davon ist.

7. Einkapselungsmaterial nach Anspruch 6, **dadurch gekennzeichnet, dass** das witterungsbeständige Polyesterharz ein Polymer aus Monomeren ist, die aus Terephthalsäure, m-Phthalsäure, Neopentylglykol, Adipinsäure, Ethylenglykol oder einer Mischung davon ausgewählt sind.

8. Einkapselungsmaterial nach Anspruch 1, **dadurch gekennzeichnet, dass** das Härtungsmittel 2-20 Gew.-% der witterungsbeständigen Polyester-Pulverbeschichtung ausmacht und das Härtungsmittel 1,3,5-Triglycidylisocyanurat, Triglycidyltrimellitat (TML), Diglycidylterephthalat, Glycidylmethacrylat (GMA), Hydroxyalkylamid, Isocyanat oder eine Mischung davon ist.

9. Einkapselungsmaterial nach Anspruch 8, **dadurch gekennzeichnet, dass** die witterungsbeständige Polyester-Pulverbeschichtung ferner ein Zusatzstoff enthält; das Zusatzstoff macht 0-40 Gew. % der witterungsbeständigen Polyester-Pulverbeschichtung ausmacht und der Zusatzstoff Polyamidwachs, Polyolefinwachs, amidmodifiziertes phenolisches Harnstofftensid, Benzoin, Poly(dimethylsiloxan), Vinyltrichlorsilan, n-Butyltriethoxylsilan, Tetramethoxysilan (TMOS), Monoalkoxypyrophosphat, Acryl, Phenolharz, Harnstoff-Formaldehydharz, Melamin-Formaldehydharz Distearoylethylendiamin, ein Gemisch aus Ethylenoxid und Propylenoxid, gehindertes Phenol, Thiodipropionat, Diphenylketon, Salicylatderivate, gehindertes Amin, Aluminiumoxid, pyrogene Kieselsäure, Tetrabrombisphenol A, Decabromdiphenylethan, Trikresylphosphat, Aluminiumhydroxid, Magnesiumhydroxid, Bariumsulfat, Titandioxid, Ruß oder einer Mischung davon ist.

10. Herstellungsverfahren zur des Einkapselungsmaterial für ein photovoltaisches Modul nach einem der Ansprüche 1 bis 9, wobei das Herstellungsverfahren umfasst:
1) Gleichmäßige Verteilung der wetterfesten Polyester-Pulverbeschichtung auf dem Fasergewebe mit Hilfe eines Beschichtungsgerätes;
2) Thermische Verbindung der witterungsbeständigen Polyester-Pulverbeschichtung und des Fasergewebes durch Druck und Erhitzen;
3) stückweises Schneiden eines Produkts, das durch thermisches Verbinden der wetterfesten Polyester-Pulverbeschichtung und des Fasergewebes in 2) erhalten wurde; und
4) Sammeln eines Einkapselungsmaterial für ein photovoltaisches Modul.

11. Herstellungsverfahren nach Anspruch 10, **dadurch gekennzeichnet, dass** das thermische Verbinden mit den folgenden Parametern durchgeführt wird: ein Druck liegt zwischen 0,05 und 0,25 Megapascal, eine Heiztemperatur liegt zwischen 90 und 130°C, und eine Heizzeit liegt zwischen 5 und 20 Sekunden.

## Revendications

1. Un matériau d'encapsulation pour un module photovoltaïque, le matériau d'encapsulation comprenant
entre 30 à 50 parties en poids d'un tissu de fibres, le tissu de fibres étant formé d'un matériau fibreux; et
entre 50 à 70 parties en poids d'un revêtement en poudre de polyester résistant aux intempéries, le revêtement en poudre de polyester résistant aux intempéries comprend une résine de polyester résistant aux intempéries et un agent de durcissement, et le revêtement en poudre de polyester résistant aux intempéries est réparti uniformément sur le tissu en fibres.

2. Matériau d'encapsulation selon la revendication 1, **caractérisé par le fait que** le poids par unité de surface du tissu de fibres est compris entre 30 à 400 g/m², et que le poids par unité de surface du revêtement en poudre de polyester résistant aux intempéries distribué sur le tissu de fibres est compris entre 100 à 400 g/m².

3. Matériau d'encapsulation selon la revendication 1, **caractérisé par le fait que** le matériau fibreux est une fibre de verre, une fibre de carbone, une fibre aramide ou un mélange de celles-ci.

4. Matériau d'encapsulation selon la revendication 1, **caractérisé en ce qu'**un diamètre de monofilament du matériau fibreux est compris entre 3 à 23 µm.

5. Matériau d'encapsulation selon la revendication 1, **caractérisé par le fait que** le tissu de fibres comprend un matériau de fibres sous la forme d'une armure toile, d'une armure sergé, d'une armure satin, d'une armure nervurée, d'une armure mat, ou d'une combinaison de celles-ci.

6. Matériau d'encapsulation selon la revendication 1, **caractérisé par le fait que** la résine polyester résistante aux intempéries est une résine polyester résistante aux intempéries hydroxyle, une résine polyester carboxyle ou un mélange de celles-ci.

7. Matériau d'encapsulation selon la revendication 6, **caractérisé par le fait que** la résine polyester résistante aux intempéries est un polymère de monomères choisis parmi l'acide téréphtalique, l'acide m-phtalique, le néopentylglycol, l'acide adipique, l'éthylène glycol, ou un mélange de ceux-ci.

8. Matériau d'encapsulation selon la revendication 1, **caractérisé par le fait que** l'agent de durcissement représente 2 à 20 % en poids du revêtement en poudre de polyester résistant aux intempéries, et que l'agent de durcissement est le 1,3,5-triglycidyl isocyanurate, le triglycidyl trimellitate (TML), le diglycidyl téréphtalate, le méthacrylate de glycidyle (GMA), l'amide d'hydroxyalkyle, l'isocyanate, ou un mélange de ceux-ci.

9. Matériau d'encapsulation selon la revendication 8, **caractérisé par le fait que** le revêtement en poudre de polyester résistant aux intempéries comprend en outre un additif; l'additif représente 0-40. % en poids du revêtement en poudre de polyester résistant aux intempéries, et l'additif est une cire de polyamide, une cire de polyoléfine, un tensioactif d'urée phénolique modifié par un amide, du benjoin, du poly(diméthylsiloxane), du trichlorosilane de vinyle, du n-butyl triéthoxyl silane, du tétraméthoxysilane (TMOS), du monoalkoxy pyrophosphate, des acryliques, de la résine phénolique, de la résine urée-formaldéhyde, de la résine de mélamine-formaldéhyde, distéaroyl éthylènediamine, mélange d'oxyde d'éthylène et d'oxyde de propylène, phénol encombré, thiodipropionate, cétone diphényle, dérivés de salicylate, amine encombrée, alumine, silice pyrogénée, tétrabromobisphénol A, décabromodiphényl éthane, phosphate tricrésyle, hydroxyde d'aluminium, hydroxyde de magnésium, sulfate de baryum, dioxyde de titane, noir de carbone, ou un mélange de ceux-ci.

10. Méthode de préparation d'un matériau encapsulant pour un module photovoltaïque selon l'une des revendications 1 à 9, la méthode comprenant ce quis suit:
1) Répartir uniformément le revêtement en poudre de polyester résistant aux intempéries sur le tissu en fibres à l'aide d'un dispositif d'enduction ;
2) Lier thermiquement le revêtement en poudre de polyester résistant aux intempéries et le tissu de fibres en utilisant la pression et la chaleur;
3) Couper par morceaux le produit obtenu en liant thermiquement l'enduit de poudre de polyester résistant aux intempéries et le tissu de fibres en 2); et
4) Collecte d'un matériau encapsulant pour un module photovoltaïque.

11. Méthode selon la revendication 10, **caractérisée par le fait que** la liaison thermique est mise en oeuvre avec les paramètres suivants: une pression comprise entre 0,05 à 0,25 mégapascal, une température comprise entre 90 à 130°C et un temps de chauffage compris entre 5 et 20 secondes.
